# EUROPEAN PATENT APPLICATION

(11) **EP 4 636 786 A1**
(43) Date of publication of application: **22.10.2025**
(21) Application number: 23903265.9
(22) Date of filing: 28.11.2023
(51) Int. Cl.: H01B 13/00, B05D 3/10, B05D 3/12, B05D 5/12, C23C 24/08, H05K 3/12

(54) **METHOD FOR PRODUCING CONDUCTIVE BASE MATERIAL, METHOD FOR PRODUCING ELECTRONIC DEVICE, METHOD FOR PRODUCING ELECTROMAGNETIC SHIELDING FILM, METHOD FOR PRODUCING SHEET-LIKE HEATING ELEMENT AND CONDUCTIVE BASE MATERIAL**

(30) Priority: 15.12.2022 JP 2022199931
(71) Applicant: SATO Corporation, Tokyo 108-0023 (JP)
(72) Inventor: OGAWA Takayuki, Tokyo 108-0023 (JP); SHIBATA Takeshi, Tokyo 108-0023 (JP)
(74) Representative: Grünecker Patent- und Rechtsanwälte PartG mbB
(86) International application number: PCT/JP2023/042508
(87) International publication number: WO 2024/127974

(57) **Abstract**

A method for producing a conductive base material, the method includes: (1) a laminating step of forming a conductive particle-containing layer on a surface of a base material using a conductive composition containing conductive particles, to obtain a laminate including a base material layer and the conductive particle-containing layer; (2) an impregnation step of impregnating a component (X) capable of removing an oxide film on a surface of the conductive particles into the conductive particle-containing layer; and (3) a conductive film formation step of at least pressurizing the conductive particle-containing layer impregnated with the component (X) to form a conductive film.

## Description

### TECHNICAL FIELD

The present invention relates to a method for producing a conductive base material, a method for producing an electronic device, a method for producing an electromagnetic shield film, a method for producing a sheet-like heating element, and a conductive base material.

### BACKGROUND ART

A technique of applying a conductive composition containing conductive particles onto a base material to provide a conductive particle-containing layer, and heating and pressurizing the conductive particle-containing layer to form a conductive base material containing a conductive film is known.

As an example, the Examples of Patent Document 1 describe coating a dispersion of silver fine particles having an average primary particle size of 7 nm in water/ethylene glycol on a PET film to form a coating film and then heating and pressing the coating film at 150°C, as well as forming a conductive layer by means of this step.

As another example, the Examples of Patent Document 2 describe spin-coating a copper fine particle dispersion liquid (copper nano-ink) having copper fine particles (copper nanoparticles) having a median diameter of approximately 40 nm, a dispersion medium, and a dispersant on a glass base material to form a coating film and then baking the coating film to form a conductive film.

As a further example, Patent Document 3 describes coating a conductive ink composition containing (A) an oxycarboxylic acid, (B) a nitrogen-containing compound, (C) copper particles, and (D) a dispersion medium on a base material to form a coating film and then treating the coating film to form a conductive layer.

### RELATED DOCUMENT

### PATENT DOCUMENT

Patent Document 1: Japanese Patent No. 6181608
Patent Document 2: Japanese Unexamined Patent Publication No. 2021-044308
Patent Document 3: Japanese Unexamined Patent Publication No. 2017-191723

### SUMMARY OF THE INVENTION

### TECHNICAL PROBLEM

In a case where a conductive film is formed using a conductive composition containing conductive particles, it is preferable that the specific resistance of the formed conductive film is as low as possible. However, for conductive films obtained by producing methods known in the related art, such as Patent Documents 1 to **3,** there is room for further reduction in resistivity.

In consideration of the above circumstances, the inventors of the present invention have conducted various studies with one of the objects of producing a conductive base material having a conductive film with a small specific resistance, using a conductive composition containing conductive particles.

### SOLUTION TO PROBLEM

The present inventors completed the inventions provided below and solved the above-described problems.

The present invention is as follows.

1. A method for producing a conductive base material, the method including:
   a laminating step of forming a conductive particle-containing layer on a surface of a base material using a conductive composition containing conductive particles, to obtain a laminate containing a base material layer and the conductive particle-containing layer;
   an impregnation step of impregnating a component (X) capable of removing an oxide film on a surface of the conductive particles into the conductive particle-containing layer; and
   a conductive film formation step of at least pressurizing the conductive particle-containing layer impregnated with the component (X) to form a conductive film.
2. The method for producing a conductive base material according to 1., further including:
   a pressurizing step of at least pressurizing the conductive particle-containing layer between the laminating step and the impregnation step.
3. The method for producing a conductive base material according to 2.,
   in which, in a case where a pressure applied to the conductive particle-containing layer in the pressurizing step is denoted by P1 and a pressure applied to the conductive particle-containing layer in the conductive film formation step is denoted by P2, P1 < P2 is satisfied.
4. The method for producing a conductive base material according to any one of 1. to 3.,
   in which in the impregnation step, a liquid in which the component (X) is dissolved or dispersed is impregnated into the conductive particle-containing layer.
5. The method for producing a conductive base material according to 4.,
   in which the liquid contains water.
6. The method for producing a conductive base material according to 4. or 5.,
   in which the liquid in which the component (X) is dissolved or dispersed is supplied to at least a surface of the conductive particle-containing layer by any one of a dropping method, a spraying method, or an immersion method between the laminating step and the impregnation step.
7. The method for producing a conductive base material according to any one of 1. to 3.,
   in which in the impregnation step, the component (X) is impregnated into the conductive particle-containing layer by bringing a sheet containing the component (X) into contact with the conductive particle-containing layer.
8. The method for producing a conductive base material according to any one of 1. to 7.,
   in which in the conductive film formation step, the conductive particle-containing layer is pressurized while being heated.
9. The method for producing a conductive base material according to any one of 1. to 8.,
   in which, in the conductive film formation step, a surface of the laminate on which the conductive particle-containing layer is provided is covered with a film-like material, and then the conductive particle-containing layer is at least pressurized.
10. The method for producing a conductive base material according to any one of 1. to 9.,
   in which the impregnation step and the conductive film formation step are performed at the same time.
11. The method for producing a conductive base material according to any one of 1. to 9.,
   in which the conductive film formation step is performed after the impregnation step.
12. The method for producing a conductive base material according to any one of 1. to 11., further including:
   a removing step of removing the component (X) remaining on a surface or inside the conductive film after the conductive film formation step.
13. The method for producing a conductive base material according to any one of 1. to 12.,
   in which the component (X) includes at least one selected from the group consisting of an organic acid, an oxoacid of phosphorus, and hydrazine or a derivative thereof.
14. The method for producing a conductive base material according to any one of 1. to 13.,
   in which the conductive composition contains one or both of a resin and a binder.
15. The method for producing a conductive base material according to any one of 1. to 13.,
   in which the conductive composition substantially does not contain a resin and substantially does not contain a binder.
16. The method for producing a conductive base material according to any one of 1. to 15.,
   in which the base material is flexible.
17. The method for producing a conductive base material according to any one of 1. to 16.,
   in which the base material is at least one selected from the group consisting of polyester, polyolefin, polyimide, and paper.
18. The method for producing a conductive base material according to any one of 1. to 17.,
   in which the impregnation step is performed by applying pressure to the conductive particle-containing layer with a pressing member.
19. The method for producing a conductive base material according to any one of 1. to 18.,
   in which the impregnation step is performed as any one of the following (i) to (iii).
   (i) The laminate is transported between two rolls facing each other while the laminate is interposed between the two rolls.
   (ii) The laminate is placed on a flat plate or a flat surface of a base having the flat surface, a roll is brought into contact with the laminate from above, and pressure is applied to the laminate while rotating the roll.
   (iii) The laminate is interposed between a first flat surface of a first pressing member having the first flat surface and a second flat surface of a second pressing member having the second flat surface.
20. The method for producing a conductive base material according to any one of 1. to 19.,
   in which the conductive film has a pattern structure.
21. The method for producing an electronic device,
   in which an electronic device is produced using the conductive base material obtained by the method for producing a conductive base material according to any one of 1. to 20..
22. The method for producing an electronic device according to 21.,
   in which the electronic device is an RF tag.
23. A method for producing an electromagnetic shield film,
   in which an electromagnetic shield film is produced using the conductive base material obtained by the method for producing a conductive base material according to any one of 1. to 20..
24. A method for producing a sheet-like heating element,
   in which a sheet-like heating element is produced using the conductive base material obtained by the method for producing a conductive base material according to any one of 1. to 20..
25. A conductive base material containing:
   a base material; and
   a conductive film provided on at least a part of a surface of the base material using a conductive composition containing conductive particles,
   in which a component (X) capable of removing an oxide film on a surface of the conductive particles is present on a surface or inside the conductive film.

### ADVANTAGEOUS EFFECTS OF INVENTION

According to the present invention, it is possible to form a conductive film having a small specific resistance using a conductive composition containing conductive particles.

### BRIEF DESCRIPTION OF THE DRAWINGS

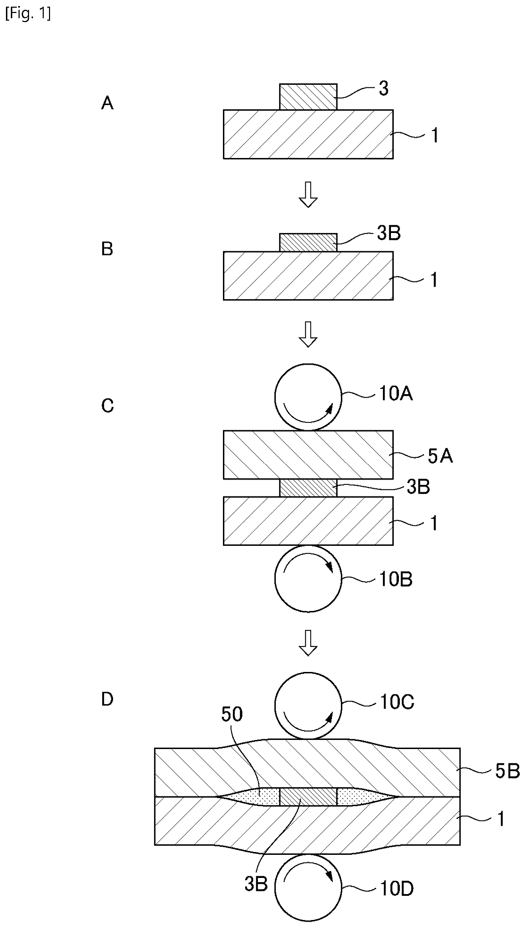

[Fig. 1] A view for explaining a method of producing a conductive base material.

### DESCRIPTION OF EMBODIMENTS

A detailed explanation will be given below of an embodiment of the present invention with reference to the drawings.

In all the drawings, the same components are given the same reference numerals and explanations thereof will not be repeated as appropriate.

To avoid complexity, in a case where there are a plurality of identical constituent components in the same drawing, only one thereof may be labeled with a reference numeral, or not all thereof may be provided with a reference numeral.

The drawings are for illustrative purposes only. The shapes, dimensional ratios, and the like of each of the members in the drawings do not necessarily correspond to the actual products.

In the present specification, the notation "X to Y" in the explanation of the range of values means equal to or more than X and equal to or less than Y, unless otherwise specified. For example, "1 to 5% by mass" means "equal to or more than 1% by mass and equal to or less than 5% by mass".

The expression "(meth)acryl" in the present specification represents a concept including both acryl and methacryl. The same applies to similar expressions such as "(meth)acrylate".

### <Method for Producing Conductive Base Material>

The producing method for a conductive base material according to the present embodiment includes a laminating step of obtaining a laminate containing a base material layer and a conductive particle-containing layer by using a conductive composition containing conductive particles on a surface of a base material, an impregnation step of impregnating the conductive particle-containing layer with a component (X) capable of removing an oxide film on a surface of the conductive particles, and a conductive film formation step of at least pressurizing the conductive particle-containing layer impregnated with the component (X) to form a conductive film.

According to the findings of the present inventors, in a case where a conductive film is formed by a conventionally known producing method using a conductive composition containing conductive particles, the specific resistance of the obtained conductive film tends to be increased due to the oxide film present on the surface of the conductive particles.

In consideration of this point, the present inventors have removed at least a part of the oxide film on the surface of the conductive particles using a component (X) capable of removing the oxide film on the surface of the conductive particles in a case of forming a conductive film using a conductive composition containing conductive particles. As a result, the specific resistance of the obtained conductive film could be reduced.

Hereinafter, an example of the method for producing a conductive base material according to the present embodiment will be described in more detail with reference to the drawings.

### [Laminating Step: Film Formation Using Conductive Composition (A In Fig. 1) and Drying of Film (B In Fig. 1)]

In the laminating step, for example, first, as shown in A of Fig. 1, a film 3 is formed on the surface of the base material 1 using a conductive composition containing conductive particles.

In a case where the conductive composition contains a volatile solvent, the volatile solvent in the film 3 is volatilized to form the conductive particle-containing layer 3B (dry film). In this manner, a laminate containing the base material 1 (base material layer) and the conductive particle-containing layer 3B can be obtained. Of course, the laminating step is not limited only to the aspects shown in A and B of Fig. 1 as long as a laminate containing the base material 1 and the conductive particle-containing layer 3B can be obtained.

The base material 1 is usually in the form of a film, sheet, or plate. From the viewpoint of industrial productivity, the shape of the base material 1 is preferably one of the above.

The base material 1 is preferably flexible. By adopting the base material 1 having flexibility, it is possible to produce a flexible printed circuit board (FPC).

In addition, by using the base material 1 having flexibility, it is easy to form a conductive film using a "roll" in the conductive film formation step described later. This is preferable from the viewpoint of mass productivity.

To be clear, the base material 1 may be a rigid base material that does not have flexibility.

In consideration of cost and the final use, the base material 1 is preferably at least one selected from the group consisting of polyesters such as PET (polyethylene terephthalate) and PEN (polyethylene naphthalate), polyolefins such as polyethylene and polypropylene, polyimide, and paper. Here, the paper may be coated paper (paper for which the surface is coated with a coating agent) or ordinary paper that is not coated paper. In addition, the base material 1 is not limited to PET or the like and it is possible to adopt a general resin film.

In the present embodiment, in the conductive film formation step, a conductive film having a sufficiently small specific resistance can be obtained even without heating or by heating at a relatively low temperature. Therefore, it is also possible to suitably use the base material 1 having low heat resistance such as polyester, polyolefin, and paper, as the base material. In addition, when the base material 1 having high heat resistance such as polyimide is used, it is possible to further reduce the resistivity by performing high-temperature heating in the conductive film formation step.

The method of forming a film using the conductive composition is not particularly limited. As a method of forming a film, various coating and printing techniques can be applied.

The film 3 and/or the conductive particle-containing layer 3B may be provided on the entire one surface of the base material 1 or may be provided only on a part of the one surface of the base material 1. In the former case, the film 3 can be formed by coating using a device such as a blade coater, an air knife coater, a doctor coater, a roll coater, a bar coater (rod coater), or a curtain coater. In the latter case, the film 3 can be formed by various printing methods, for example, a screen printing method, a gravure printing method, a relief printing method, a flat printing method (offset printing method), an ink jet method, and a transfer printing method. By appropriately designing the "pattern" of the coating, it is possible to produce a base material provided with a pattern structure, such as a conductive film (circuit pattern) able to function as a circuit or a mesh pattern that has an electromagnetic shielding ability. In a case where the conductive composition is provided only on a part of one surface of the base material 1, the "pattern" of the printing is preferably appropriately designed according to the application of the finally obtained conductive film.

In order to prevent the film 3 from being formed at a place other than a desired place in the base material 1, for example, a film having holes may be placed on the base material 1, the conductive composition may be applied or printed thereon, and then the film may be removed.

From the viewpoint of obtaining sufficient conductivity in a case of being formed into a conductive film and the viewpoint of ease of application or printing, the amount of the conductive composition to be used may be appropriately adjusted. Specifically, the thickness of the film 3 or the thickness of the conductive particle-containing layer 3B is preferably 5 to 100 µm and more preferably 10 to 50 µm.

In particular, in a case where the conductive composition contains a solvent, it is preferable to perform a heating treatment for drying the solvent to obtain the film 3 as a conductive particle-containing layer 3B (dry film). The conditions of the heating treatment are not particularly limited as long as the solvent is sufficiently dried, but are adjusted from the viewpoint of sufficiently drying the solvent and suppressing the deterioration of the conductive particles due to excessive heating. The temperature of the heating treatment is preferably 50°C to 150°C and more preferably 80°C to 120°C. The heat treatment time is preferably 1 to 60 minutes and more preferably 3 to 30 minutes.

The heating treatment for drying the solvent can be performed, for example, by blowing hot air to the film 3. Naturally, the heat treatment may be performed by other methods.

Specific aspects of the conductive composition will be described later.

### [Pressurizing Step (C) in Fig. 1]

In the present embodiment, it is preferable that a pressurizing step of pressurizing the conductive particle-containing layer 3B is at least included between the above-described laminating step and an impregnation step described later.

It is optional whether or not to carry out the pressurizing step, but by carrying out this step, the form of the conductive particle-containing layer 3B is easily maintained in the subsequent step (particularly, the impregnation step). In particular, in a case where a liquid in which the component (X) is dissolved or dispersed is allowed to impregnate into the conductive particle-containing layer 3B in the impregnation step, it is easy to suppress at least a part of the conductive particle-containing layer 3B from being deformed or collapsed due to the liquid.

In particular, in a case where a conductive composition that does not substantially contain a resin or a binder is used, the conductive particle-containing layer 3B before becoming a conductive film is likely to deform or collapse, and thus it is preferable to carry out the pressurizing step.

On the other hand, in a case where a conductive composition containing a resin or a binder is used, the conductive particle-containing layer 3B is less likely to deform or collapse than a conductive composition that does not substantially contain a resin or a binder, and thus the form of the conductive particle-containing layer 3B may be sufficiently maintained even without carrying out the pressurizing step.

The pressurizing step can be performed, for example, as shown in C of Fig. 1, by transporting the laminate containing the base material 1 and the conductive particle-containing layer 3B between two rolls 10A and 10B facing each other while the laminate is interposed between the two rolls.

In the pressurizing step, as shown in C of Fig. 1, a part or the whole of the surface of the laminate on which the conductive particle-containing layer 3B is provided may be covered with the film-like material 5A, and then the conductive particle-containing layer 3B may be pressurized by applying the roll 10A from the film-like material 5A.

By using the film-like material 5A, the roll 10A is prevented from being in direct contact with the conductive particle-containing layer 3B, and thus it is easy to suppress the unintended deformation or collapse of the conductive particle-containing layer 3B. In addition, the film-like material 5A acts as a "buffering material", which makes it easy to uniformly apply pressure to the conductive particle-containing layer 3B. It is preferable to uniformly apply pressure to the conductive particle-containing layer 3B, since this leads to uniform impregnation of the component (X) into the conductive particle-containing layer 3B in the impregnation step. Furthermore, by using the film-like material 5A, it may be possible to prevent a part or the whole of the conductive particle-containing layer 3B from being peeled off and attached to the roll 10A.

From one viewpoint, the material of the film-like material 5A can be the same as that of the base material 1. That is, the film-like material 5A can be a polyester film such as a PET film.

From a different viewpoint, a release film can be preferably used as the film-like material 5A from the viewpoint of suppressing peeling or damage of the conductive particle-containing layer 3B. The release film is usually a film in which a release agent is coated on at least one surface of a resin film, and examples of the type of the release agent include a silicone-based release agent, a fluorine-based release agent, and a non-silicone-based release agent. The release film is available from, for example, Fujimori Kogyo Co., Ltd.

From still another viewpoint, the film-like material 5A may be made of a non-resin-based material such as paper or an aluminum foil.

Incidentally, for the purpose of preventing a part or the whole of the conductive particle-containing layer 3B from being peeled off and attached to the roll 10A, instead of using the film-like material 5A, a film of a peeling agent such as a silicone-based, a fluorine-based, or a non-silicone-based may be formed on the body portion of the roll 10A.

From the viewpoint of "making it easy to maintain the form of the conductive particle-containing layer 3B in the subsequent step (particularly, the impregnation step)", the pressure in the pressurizing step is preferably high. On the other hand, from the viewpoint of easily allowing the component (X) to impregnate into the conductive particle-containing layer 3B in the impregnation step, it is preferable that the pressure in the pressurizing step is not too high so that an appropriate "gap" remains in the conductive particle-containing layer 3B.

Specifically, it is preferable that, in a case where the pressure applied to the conductive particle-containing layer 3B in the pressurizing step is denoted by P1 and the pressure applied to the conductive particle-containing layer 3B in the conductive film formation step described later is denoted by P2, P1 < P2 is satisfied. More specifically, P1 is preferably 0.9 times or less, more preferably 0.75 times or less, and still more preferably 0.6 times or less of P2. That is, it is preferable that the pressure in the pressurizing step is sufficiently lower than the pressure required for pressing or sintering the conductive particles in the conductive film formation step.

From various viewpoints, it is preferable to optimize the values of P1 and P2, respectively.

P1 is preferably 1 to 500 MPa, more preferably 10 to 200 MPa, and still more preferably 20 to 100 MPa. In a case where P1 is 1 MPa or more, an effect of easily obtaining the effect of easily maintaining the form of the conductive particle-containing layer 3B in the subsequent step (particularly, the impregnation step) is reliably and sufficiently obtained. In addition, in a case where P1 is 500 MPa or less, the "gap" for impregnation of the component (X) is likely to remain sufficiently in the conductive particle-containing layer 3B.

In addition, P2 is preferably 10 MPa or more, more preferably 10 to 5,000 MPa, still more preferably 20 to 300 MPa, and particularly preferably 30 to 250 MPa. By applying P2, which is a pressure of 10 MPa or more, it is possible to further reduce the resistivity of the obtained conductive film. In addition, since the pressure is 5,000 MPa or less, damage to the base material 1 or the conductive particle-containing layer 3B can be suppressed. Incidentally, when the base material 1 has sufficient strength, it is possible to further reduce the resistivity of the conductive film by increasing the pressure.

For the sake of completeness, the pressurizing step may be performed by means other than the means for transporting the laminate by pinching the laminate between the two rolls 10A and 10B as shown in C of Fig. **1****.**

As an example, in the pressurizing step, the laminate may be placed on a flat plate or a flat surface of a base having the flat surface, a roll may be brought into contact with the laminate, and pressure may be applied to the laminate while rotating the roll. As another example, the pressurizing step may be performed by sandwiching the laminate between a first flat surface of a first pressing member having a first flat surface and a second flat surface of a second pressing member having a second flat surface. Even in these examples, the pressure may be applied to the laminate through the film corresponding to the film-like material 5A in C of Fig. **1****.**

In short, in the pressurizing step, it is sufficient that pressure is applied to the conductive particle-containing layer 3B before the impregnation step.

In the pressurizing step, it is preferable to apply heat to the conductive particle-containing layer 3B. It is presumed that this is related to the surface treatment of the commercially available conductive particles. Specifically, a part of the surface of the commercially available conductive particles may be subjected to a surface treatment with an organic substance, and it is considered that the organic substance on the surface of the conductive particles is removed or moved by applying heat to the conductive particle-containing layer 3B. As a result, the contact between the conductive particles may be promoted.

In a case where the conductive particle-containing layer 3B is heated in the pressurizing step, the temperature is preferably set to a temperature at which the base material 1 is not substantially altered (softened, melted, or the like), for example, in a range of 50°C to 150°C, more preferably in a range of 70°C to 140°C, and still more preferably in a range of 70°C to 130°C. However, in a case where the heating time is short, heating at a higher temperature may be allowed.

Of course, the conductive particle-containing layer 3B may not be heated in the pressurizing step.

In a case where the film-like material 5A is used in the pressurizing step, the next step is usually performed after the film-like material 5A is peeled off from the base material 1 and the conductive particle-containing layer 3B.

### [Impregnation Step and Conductive Film Formation Step (D in Fig. 1)]

In the impregnation step, a component (X) capable of removing the oxide film on the surface of the conductive particles is impregnated into the conductive particle-containing layer 3B. In addition, in the conductive film formation step, the conductive particle-containing layer 3B in which the component (X) has impregnated is pressurized at least to form a conductive film.

Although not shown in Fig. 1, it is necessary to supply the component (X) to the conductive particle-containing layer 3B before the impregnation step. The specific means for the supply is not particularly limited, and examples thereof include dropping, spraying, and immersion, which will be described later.

From the viewpoint of ease of performing the process and ease of impregnation of the component (X) into the conductive particle-containing layer 3B, in the impregnation step, a liquid in which the component (X) is dissolved or dispersed is preferably impregnated into the conductive particle-containing layer 3B. More preferably, in the impregnation step, water in which the component (X) is dissolved or dispersed is impregnated into the conductive particle-containing layer 3B. It is preferable to use "water" in which the component (X) is dissolved or dispersed from the viewpoint of reducing environmental load and safety of the process (non-flammability). Of course, an organic solvent in which the component (X) is dissolved or dispersed can also be used.

In the impregnation step, in a case where a liquid in which the component (X) is dissolved or dispersed is impregnated into the conductive particle-containing layer 3B, a method of supplying the liquid to at least the surface of the conductive particle-containing layer 3B is not particularly limited. Specific examples of the method include dropping, spraying, and immersion.

In addition, in a case where the film-like material 5B described later is used, first, at least a part of the upper surface of the film-like material 5B may be wetted with a liquid in which the component (X) is dissolved or dispersed, and then the conductive particle-containing layer 3B of the laminate may be brought into contact with the upper surface (wet) of the film-like material 5B.

Of course, the method of supplying the liquid to at least the surface of the conductive particle-containing layer 3B is not limited to the method specifically described here.

In D of Fig. 1, the impregnation step and the conductive film formation step are performed at the same time. In D of Fig. 1, the liquid 50 containing the component (X) is promoted to impregnate into the conductive particle-containing layer 3B by the pressure of the rolls 10C and 10D, and at the same time, the conductive particle-containing layer 3B is pressurized by the pressure of the rolls 10C and 10D to be changed to a conductive film.

In a case where the impregnation step includes a step of applying pressure to the conductive particle-containing layer 3B in some form, the impregnation step and the conductive film formation step can be performed at the same time. That is, the component (X) impregnates into the conductive particle-containing layer 3B by the pressure from the outside, and the oxide film on the surface of the conductive particles is removed, and at the same time, the bonding between the interfaces of the conductive particles proceeds, and the conductive particle-containing layer 3B changes to a conductive film.

Incidentally, the specific degree of pressurization here is as shown in the numerical range indicated by "P2" described above.

One or both of the impregnation step and the conductive film formation step can be performed by applying pressure to the conductive particle-containing layer 3B with a pressing member. More specifically, the measurement can be performed as any one of the following (i) to (iii).
(i) As shown in D of Fig. 1, the laminate containing the base material 1 and the conductive particle-containing layer 3B is transported between two rolls 10C and 10D facing each other while being interposed between the two rolls.
(ii) The laminate is placed on a flat plate or a flat surface of a base having the flat surface, a roll is brought into contact therewith, and pressure is applied to the laminate while rotating the roll.
(iii) The laminate is interposed between a first flat surface of a first pressing member having a first flat surface and a second flat surface of a second pressing member having a second flat surface.

In the above description, a case where the impregnation step and the conductive film formation step are performed at the same time has been described, but of course, the conductive film formation step may be performed after the impregnation step.

As an example, first, a liquid containing the component (X) is supplied to at least a surface of the conductive particle-containing layer 3B by any method such as dropping, spraying, or immersion, and the liquid containing the component (X) is allowed to impregnate into the conductive particle-containing layer 3B under normal pressure or under pressure. Then, a conductive film formation step is performed.

As another example, a portion of the laminate, at least the conductive particle-containing layer 3B, is exposed to a "gas" containing the component (X) to impregnate the component (X) into the conductive particle-containing layer 3B, and then the conductive film formation step is performed. In this case, in a case where the component (X) is a gas at normal temperature and normal pressure, the impregnation step may be performed at normal temperature and normal pressure. In addition, in a case where the component (X) is a liquid or a solid at normal temperature and normal pressure, the component (X) may be heated and vaporized, and the vaporized component (X) may be brought into contact with the conductive particle-containing layer 3B.

In these examples, the specific aspect of the conductive film formation step after the impregnation step can be, for example, as described in (i) to (iii) above.

In a case where the conductive film formation step is performed after the impregnation step, the component (X) that has not impregnated the conductive particle-containing layer 3B in the impregnation step may or may not be removed before the conductive film formation step.

Incidentally, in a case where the conductive film formation step is performed after the impregnation step, the removal of a part of the oxide film by the component (X) may proceed even in the conductive film formation step.

In a case where the conductive film formation step is performed after the impregnation step, in order to prevent the oxide film from being formed again on the surface of the conductive particles from which the oxide film has been removed in the impregnation step, it is preferable that the time between the impregnation step and the conductive film formation step is short. Specifically, in a case where the conductive film formation step is performed after the impregnation step, the time from the end of the impregnation step to the start of the conductive film formation step is preferably 1 hour or less, more preferably 30 minutes or less, still more preferably 10 minutes or less, and particularly preferably 1 minute or less.

Alternatively, in order to prevent the oxide film from being formed again on the surface of the conductive particles from which the oxide film has been removed in the impregnation step, the laminate after the impregnation step and before the conductive film formation step may be temporarily stored in an inert gas atmosphere such as a noble gas or a nitrogen gas, may be temporarily stored in a reducing atmosphere, or may be temporarily stored in a vacuum or under reduced pressure.

In one or both of the impregnation step and the conductive film formation step, as shown in D of Fig. 1, it is preferable that a part or the whole of the surface of the laminate on which the conductive particle-containing layer 3B is provided is covered with the film-like material 5B and then the conductive particle-containing layer 3B is at least pressurized. By adopting such a pressurization process, particularly in a case where a liquid in which the component (X) is dissolved or dispersed is used, the liquid can be pressurized (and heated as necessary) while the liquid is not allowed to escape and the liquid is kept in a dense state, which is preferable.

From the viewpoint of mass productivity, it is preferable that the entire surface of the laminate on which the conductive particle-containing layer 3B is provided is covered with the film-like material 5B, and then the conductive particle-containing layer 3B is subjected to at least pressurization.

Of course, the conductive particle-containing layer 3B may be pressurized without using the film-like material 5B as long as the conductive film is finally obtained.

The material of the film-like material 5B can be the same as the material of the film-like material 5A. That is, the material of the film-like material 5B can be the same as that of the base material 1. In addition, as the film-like material 5B, a release film can be preferably used. Furthermore, the film-like material 5B may be a non-resin material such as paper or an aluminum foil.

As the film-like material 5B, the film-like material 5A may be used. That is, the film-like material 5B and the film-like material 5A can be the same. Of course, the film-like material 5B may be different from the film-like material 5A.

The material of the film-like material 5B may be the same as or different from that of the film-like material 5A.

In a case where the conductive particle-containing layer 3B is covered with the film-like material 5B and then the conductive particle-containing layer 3B is pressurized, the film-like material 5B plays a role as a buffer material, and it is easy to uniformly apply pressure to the conductive particle-containing layer 3B. As a result, a homogeneous conductive film is easily obtained.

In addition, by covering the conductive particle-containing layer 3B with the film-like material 5B and then pressurizing the conductive particle-containing layer 3B, it is possible to suppress corrosion or deterioration of the pressing member (specifically, the roll 10C in D of Fig. 1). Incidentally, from the viewpoint of suppressing corrosion or deterioration of the pressing member, instead of using the film-like material 5B, a film of a release agent such as a silicone-based, fluorine-based, or non-silicone-based release agent may be formed on at least a part of the surface of the pressing member (specifically, the body portion of the roll 10A).

Furthermore, particularly in a case where the liquid in which the component (X) is dissolved or dispersed is allowed to impregnate into the conductive particle-containing layer 3B, the presence of the film-like material 5B suppresses the liquid from "escaping" due to the pressure, and a sufficient amount of the component (X) easily impregnates into the conductive particle-containing layer 3B, which is preferable. In this regard, the film-like material 5B is preferably a material through which a liquid in which the component (X) is dissolved or dispersed does not impregnate (non-liquid permeable). Specifically, the film-like material 5B is preferably a resin film that does not usually allow a liquid to impregnate, rather than a paper that can easily allow a liquid to impregnate. Of course, in a case where a conductive film having a small specific resistance is obtained, the film-like material 5B may be a material through which a liquid in which the component (X) is dissolved or dispersed can impregnate (a material having liquid permeability). The film-like material 5B has liquid permeability, which may promote the discharge and removal of the excess liquid.

The specific aspect of the film-like material 5B can be the same as that of the base material 1. However, as described above, the film-like material 5B is preferably a resin film.

In the conductive film formation step, it is preferable to pressurize the conductive particle-containing layer 3B while heating the conductive particle-containing layer 3B.

The temperature of the "heating" here may be appropriately set according to the heat resistance of the base material 1, the type of the conductive particles to be used, and the like. For example, when the base material 1 is formed of a low heat-resistant material such as polyester, polyolefin, or paper, it is preferable to set the heating temperature in the range of, for example, 50°C to 200°C, more preferably 70°C to 180°C, even more preferably 70°C to 150°C, and particularly preferably 80°C to 125°C, taking into consideration the heat resistance temperature of the base material to be used, such that the base material does not substantially soften, melt, or the like. However, in a case where the heating time is short, heating at a higher temperature (for example, 400°C) may be allowed.

On the other hand, when the base material 1 is formed of a highly heat-resistant material such as polyimide, it is possible to set the heating temperature to 50°C to 400°C. That is, in a case of heating the conductive particle-containing layer 3B, the temperature thereof is preferably adjusted to 400°C or lower.

Incidentally, as shown in Examples described later, the heating temperature is not always better as it is higher. The specific resistance of the conductive film to be obtained does not decrease even in a case where the heating temperature is increased, or rather, it may increase. Although it is merely a guess, in a case where the heating temperature is too high, the component (X) may be altered, or the conductive particles from which the oxide film has been removed by the component (X) may be rapidly oxidized again by heat, and thus the specific resistance of the obtained conductive film may not be simply reduced.

It is also possible to appropriately set the heating time depending on the heat resistance of the base material 1, the type of conductive particles to be used, and the like. The heating time is, for example, 0.01 to 1 second and preferably 0.04 to 0.6 seconds. Incidentally, in a case where the roll pressing is adopted in the conductive film formation step, the "heating time" is a time during which the conductive particle-containing layer 3B is being heated while being pressurized by the roll 10C. As an example, when the contact width between two opposing rotating rolls is 1 mm and the speed at which the base material passes between the two rolls is v, the heating time (equal to the pressing time) is 0.59 seconds when v = 0.1 m/min, 0.04 seconds when v = 1.5 m/min, 0.06 seconds when v = 1.0 m/min, and 0.012 seconds when v = 5.0 m/min.

In the conductive film formation step, in a case where pressing with a roll as shown in D of Fig. 1 is adopted, since the conductive particle-containing layer 3B is pressurized while being heated, it is preferable that at least the roll 10C on the side close to the conductive particle-containing layer 3B among the two rolls is heated. As explained above, it is possible to appropriately set the heating temperature of the roll 10C at 400°C or lower depending on the heat resistance of the base material 1, the type of conductive particles to be used, and the like. In addition, it is possible to adjust the heating time by changing the rotation speed (that is, the transport speed) of the roll 10C and the roll 10D. The transport speed may be appropriately adjusted between 0.1 and 10 m/min, for example, while taking into consideration the securing of sufficient heating and pressing time, mass productivity, and the like.

In addition, in order to uniformly heat or shorten a heating time, not only the roll 10C but also the roll 10D may be heated.

On the other hand, as long as it is possible to obtain a conductive film having a sufficiently low resistivity, the roll 10C may not be heated and the roll 10D also may not be heated. Depending on the kind of the conductive composition used, a conductive film having a sufficiently small specific resistance may be obtained only by pressurization without heating.

In a case where a conductive film having a sufficiently small resistivity can be obtained, the conductive particle-containing layer 3B may not be heated in the conductive film formation step. In particular, when particles mainly composed of silver are used as the conductive particles, it is possible to easily obtain a conductive film having a sufficiently low resistivity by pressing alone.

In the above description, a method of impregnating the "liquid" in which the component (X) is dissolved or dispersed in the conductive particle-containing layer 3B has been mainly described, and a method in a case where the component (X) is a gas has also been briefly described. As another method different from the above-described methods, the component (X) can also be allowed to impregnate into the conductive particle-containing layer 3B by bringing a sheet containing the component (X) into contact with the conductive particle-containing layer 3B and preferably applying pressure thereto.

Specific examples of the "sheet" here include paper or a nonwoven fabric containing the component (X), and a resin sheet on which the component (X) is applied or printed on the surface.

A specific aspect of the component (X) will be described later.

### [Additional Step]

The method for producing a conductive base material according to the present embodiment may include a step other than the above-described steps.

As an example, in a case where the film-like material 5B is used in the conductive film formation step, the film-like material 5B is removed after the end of the conductive film formation step.

As another example, a removing step of removing the component (X) remaining on the surface or inside the obtained conductive film may be performed after the conductive film formation step. Specific examples thereof include a step of immersing the obtained conductive base material in a liquid (water or an organic solvent) in which the component (X) is dissolved or dispersible, and a step of "washing away" the residual component (X) by applying a liquid (water or an organic solvent) to the surface of the conductive film. In addition, a step of "vaporizing and flying" the residual component (X) by heating the obtained conductive base material at a temperature at which the base material 1 is not damaged is also considered.

### [Supplementary Note on Entire Producing Method]

Each of the above-described producing steps may be performed continuously or discontinuously. From the viewpoint of mass productivity, it is preferable that the treatment is performed continuously.

For example, it is preferable that a series of the following steps (i) to (viii) are continuously performed using a producing device in which an appropriate transport device or press device (roll press machine or the like) is combined. Incidentally, in the following series of steps, the component (X) impregnates the conductive particle-containing layer 3B in some or all of (v) to (vii).

(i) A laminate containing the base material 1 and the conductive particle-containing layer 3B is placed on the producing device.
(ii) Covering a surface of the laminate, which includes at least the conductive particle-containing layer 3B, with the film-like material 5A
(iii) Pressurizing step using press device
(iv) The film-like material 5A is peeled off.
(v) A liquid in which the component (X) is dissolved or dispersed is supplied to at least a surface of the conductive particle-containing layer 3B.
(vi) Covering a surface of the laminate, which contains at least the conductive particle-containing layer 3B (the surface to which the liquid has been supplied), with the film-like material 5B
(vii) Conductive film formation step using press device
(viii) The film-like material 5B is peeled off.

### [Conductive Composition]

The conductive composition contains at least conductive particles.

From the viewpoint of easy availability and good conductivity, the conductive particles preferably contain at least one element selected from the group consisting of silver and copper.

Specifically, the conductive particles preferably include at least one selected from the group consisting of particles mainly composed of silver and particles mainly composed of copper. Here, the expression "mainly composed of silver" means that the ratio of the silver element to all constituent elements in the particles is preferably 50 mol% or more, more preferably 75 mol% or more, even more preferably 90 mol% or more, and particularly preferably 95 mol% or more. Similarly, the expression "mainly composed of copper" means that the ratio of the copper element to all constituent elements in the particles is preferably 50 mol% or more, more preferably 75 mol% or more, even more preferably 90 mol% or more, and particularly preferably 95 mol% or more.

To be clear, the conductive particles may include elements other than silver and copper as long as the desired conductivity is obtained. Examples of elements other than silver and copper include gold, aluminum, platinum, palladium, iridium, tungsten, nickel, tantalum, lead, zinc, and the like.

The conductive particles may contain two or more elements. For example, conductive particles in which the surface of copper particles is silver-plated (silver-coated copper particles) and the like are preferably used in the present embodiment. Silver-coated copper particles are particles mainly composed of copper for which the surface of the copper particles is plated with silver in an amount of up to a maximum of 35% by mass based on the total mass of the particles, for example.

In a volume-based cumulative particle diameter distribution curve obtained in a case where the particle diameter of the conductive particles is measured by a laser diffraction scattering method, a particle diameter D₅₀ at which a cumulative frequency is 50% is preferably 0.5 to 100 µm, more preferably 0.6 to 50 µm, still more preferably 0.7 to 30 µm, and particularly preferably 0.7 to 20 µm.

In a case where D₅₀ is moderately large, the number of grain boundaries between the conductive particles per unit volume can be reduced. It is considered that this leads to a further decrease in the specific resistance of the obtained conductive film.

It is considered that the fact that D₅₀ is not too large leads to a decrease in the "gap" between the conductive particles, which leads to a further decrease in the specific resistance of the obtained conductive film.

It is possible to purchase conductive particles that are usable in the present embodiment from, for example, Dowa Electronics Materials Co., Ltd., Fukuda Metal Foil and Powder Co., Ltd., and the like.

For the purpose of adjusting and optimizing the particle size distribution or other purposes, two or more different conductive particles may be mixed and used.

From the viewpoint of further reducing the resistivity of the conductive film, the ratio of conductive particles in the conductive composition is preferably large. Specifically, the ratio of the conductive particles in the total non-volatile components of the conductive composition is preferably 95% by mass or more, more preferably 97% by mass or more, even more preferably 98% by mass or more, and particularly preferably 99% by mass or more. In other words, from the viewpoint of further reducing the specific resistance of the obtained conductive film, it is preferable that the conductive composition does not substantially contain a resin and does not substantially contain a binder. Here, the expression "substantially does not contain a resin or a binder" means that the resin or the binder is not contained at all, or the resin or the binder is contained, but the amount thereof is so small (for example, 1% by mass or less, specifically 0.5% by mass or less in the non-volatile component of conductive composition) that the effect expected from the use of the resin or the binder (specifically described below) cannot be obtained.

As long as a desired conductive film can be obtained, the conductive composition may not contain a resin or a binder.

On the other hand, from the viewpoint of easily maintaining the form of the conductive particle-containing layer 3B in the impregnation step, specifically, from the viewpoint of suppressing at least a part of the conductive particle-containing layer 3B from being deformed or collapsed by the liquid in a case where the liquid in which the component (X) is dissolved or dispersed is impregnated into the conductive particle-containing layer 3B in the impregnation step, it is preferable that the conductive composition contains one or both of the resin and the binder. The conductive composition may contain both the resin and the binder, or may contain only one of the resin or the binder and not the other.

In addition, for the purpose of simplifying the producing process of the conductive base material by omitting the pressurizing step (C in Fig. 1), a conductive composition containing one or both of the resin and the binder may be used. That is, since the conductive particle-containing layer 3B formed of the conductive composition containing one or both of the resin and the binder is not easily deformed or collapsed by the liquid containing the component (X), the form of the conductive particle-containing layer 3B is easily maintained without performing the pressurizing step (C in Fig. 1). Finally, a desired conductive film can be easily obtained.

From the viewpoint of easily maintaining the form of the conductive particle-containing layer 3B and reducing the specific resistance of the obtained conductive film, in a case where the conductive composition contains one or both of the resin and the binder, the amount thereof is preferably 1% to 5% by mass and more preferably 2% to 5% by mass with respect to all the non-volatile components of the conductive composition.

Preferred specific examples of the resin or the binder include polyvinylpyrrolidone, polyester, an epoxy resin, a (meth)acrylic resin, polyvinyl acetal, a cellulose-based resin (for example, ethyl cellulose), and a phenol resin.

It is possible for the conductive composition to contain a solvent. In a case where the conductive composition contains a solvent, the coating property or printing property of the conductive composition on the base material is improved. The solvent typically includes an organic solvent. As long as the conductive particles can be appropriately dispersed, the solvent may include water.

The type of solvent is not particularly limited. The solvent may be any solvent that does not substantially alter each of the components in the conductive composition.

The amount of the solvent used may be appropriately adjusted according to the coating/printing method of the conductive composition and the like. The usage amount of the solvent is, for example, 3 to 30% by mass in the entire conductive composition, preferably 5 to 25% by mass, and more preferably 10 to 20% by mass.

The conductive composition may or may not contain various other additive components in ink compositions and conductive pastes in the related art.

### [Regarding component (X)]

The component (X) is not particularly limited as long as it can remove the oxide film on the surface of the conductive particles.

In the present specification, the "removal" of the oxide film includes not only a case where the oxide itself present on the surface of the conductive particles is removed but also a case where the oxide is returned to a non-oxide by a chemical change (reduction or the like).

According to the findings of the present inventors, it is preferable to contain at least one selected from the group consisting of an organic acid, an oxoacid of phosphorus, and hydrazine or a derivative thereof. These are particularly suitable in a case where the conductive particles contain copper or silver.

Examples of the organic acid include carboxylic acids such as citric acid, formic acid, acetic acid, malonic acid, malic acid, tartaric acid, ascorbic acid, succinic acid, fumaric acid, and propionic acid.

Specific examples of the oxoacid of phosphorus include phosphinic acid, phosphonic acid, phosphorous acid, phosphoric acid, diphosphoric acid, triphosphoric acid, and metaphosphoric acid. Among these, phosphinic acid is particularly preferable.

Examples of hydrazine or a derivative thereof include hydrazine itself; hydrazine salts such as monohydrazine hydrochloride, dihydrazine hydrochloride, monobromohydrazine hydrochloride, and hydrazine sulfate; and other compounds having a -NH-NH₂ structure.

In addition, from the viewpoint of removing the oxide film, a compound having a small pKa in water can be used as the component (X). Specifically, a compound having a pKa in water of -5.0 to 5.0 is preferable as the component (X), and a compound having a pKa of -4.0 to 4.5 is more preferable as the component (X). Incidentally, in a case where the component (X) is a polybasic acid, it is preferable that the smallest pKa among the plurality of pKa's is within the above-described range.

In a case of considering only the smallness of the pKa and the removability of the oxide film due to the smallness of the pKa, it is also considered to use an inorganic acid such as hydrochloric acid, nitric acid, or sulfuric acid as the component (X). However, in consideration of the defects in a case where the component (X) remains in the conductive particle-containing layer 3B, an organic acid is preferable as the component (X).

Here, a value of pKa at room temperature (for example, 25°C) can be adopted. However, from the viewpoint of the removability of the oxide film in the actual process, it can be said that it is preferable to adopt the pKa value at the temperature in the impregnation step or the conductive film formation step.

In addition, a compound that can restore the oxide film to a non-oxidized state by a reduction reaction can also be used as the component (X). For example, the compound having an aldehyde group may be used as the component (X) because the compound may reduce an oxide.

Furthermore, a compound which has a small pKa in water and can return the oxide film to a non-oxidized state by a reduction reaction is also preferably used as the component (X). Examples of such a compound include formic acid. Formic acid has the advantage of being easily volatilized and hardly remaining in the conductive film.

In addition to the above, examples of the component (X) include pyrogallol, phenidone, hydroquinone, and orthoaminophenol. These are substances known to function as reducing agents in the field of silver photographic emulsions.

In a case where a conductive film having a smaller specific resistance in a case where a certain compound A is impregnated into the conductive particle-containing layer 3B than in a case where the compound A is not impregnated into the conductive particle-containing layer 3B can be obtained, the compound A can be adopted as the component (X).

In the impregnation step, in a case where the liquid in which the component (X) is dissolved or dispersed is impregnated into the conductive particle-containing layer 3B, the concentration of the component (X) in the liquid may be appropriately adjusted. The concentration is adjusted from the viewpoint of allowing a sufficient amount of the component (X) to impregnate into the conductive particle-containing layer 3B and from the viewpoint of suppressing corrosion or deterioration of the conductive film by reducing the amount of the residual component (X).

The concentration of the component (X) in the liquid is, for example, 0.05 to 50 mol/L, preferably 0.1 to 40 mol/L, more preferably 0.1 to 30 mol/L, still more preferably 0.1 to 10 mol/L, and particularly preferably 0.15 to 5.0 mol/L. Of course, a liquid containing the component (X) may be used at a concentration lower than the concentration shown here, or a liquid containing the component (X) may be used at a concentration higher than the concentration shown here (for example, a saturated concentration).

### <Conductive Base Material>

The conductive film of the conductive base material obtained as described above has good electrical conductivity.

The conductive film of the conductive base material obtained as described above may or may not include the component (X) on the surface or inside the conductive film due to the producing method. That is, in the present embodiment, the conductive base material includes a base material and a conductive film (provided using a conductive composition including conductive particles) provided on at least a part of a surface of the base material, and the component (X) can be present on a surface or inside the conductive film.

The component (X) present on the surface or inside the conductive film can be confirmed by various measurement and observation methods. For example, by observing the conductive film with an electron microscope, it may be possible to observe a salt generated by a reaction between the conductive particles and the component (X). In addition, the component (X) present on the surface or inside the conductive film may be detected by a method such as a transmission electron microscope, an X-ray diffraction method, a nuclear magnetic resonance method, an infrared spectroscopic measurement, an ultraviolet-visible absorption spectroscopic measurement, or a Raman spectroscopic measurement.

### <Method for Producing Electronic Device>

An electronic device can be produced using the conductive base material obtained as described above. For example, in a case where the film 3 is formed only on a part of one surface of the base material 1 by printing in the laminating step, a base material including a conductive film (circuit pattern) that can function as a circuit can be produced by appropriately designing the "pattern" of the printing. Then, by combining the base material with another electronic element, it is possible to produce an electronic device.

Here, some examples of the "electronic device" will be described. For the sake of completeness, the electronic device containing the conductive base material obtained by the method for producing a conductive base material according to the present embodiment is not limited thereto.
- Sensor: For example, it is possible to apply the conductive base material obtained by the method for producing a conductive base material of the present embodiment in a conductive member/circuit in a sensor such as a pressure sensor or a vital sensor.
- Solar cell: For example, it is possible to apply the conductive base material obtained by the method for producing a conductive base material of the present embodiment in the current collector wiring of a solar cell.
- Membrane switch: A membrane switch is a thin sheet-like switch in which a circuit and contacts are printed on a film and then laminated. It is possible to apply the method for producing a conductive base material of the present embodiment to form the circuit and contacts.
- Touch sensor/touch panel: For example, it is possible to apply the method for producing a conductive base material of the present embodiment to form the lead-out wiring in a touch sensor/touch panel. In addition, it is also conceivable to apply the method for producing a conductive base material of the present embodiment to form transparent electrodes in a touch sensor/touch panel.
- Flexible base material: In the related art, a circuit is formed by first coating the entire surface of a flexible film with a metal film and then removing unnecessary parts of the metal film using a chemical agent. Instead of such methods of the related art, it is conceivable to form a circuit by the method for producing a conductive base material of the present embodiment.

In particular, in electronic devices of the related art in which circuits are formed using conductive paste, it is possible to expect that using the method for producing a conductive base material of the present embodiment for forming a circuit will reduce the resistivity of the circuit and improve the performance of the electronic device.

Examples of particularly preferable electronic devices include an RF tag. That is, the method for producing a conductive base material of the present embodiment is preferably used to produce a conductive circuit such as an antenna part in an RF tag.

For the specific structure of an RF tag, for example, it is possible to refer to Japanese Unexamined Patent Application, First Publication No. 2003-332714, Japanese Unexamined Patent Application, First Publication No. 2020-46834, and the like.

### <Method for Producing Electromagnetic Shield Film>

As an application other than electronic devices, it is conceivable to produce an electromagnetic shield film by the method for producing a conductive base material of the present embodiment. Specifically, in the laminating step, it is possible to produce an electromagnetic shield film by setting the pattern when printing the conductive composition to be a pattern specific to an electromagnetic shield film (a mesh pattern or the like).

### <Method for Producing Sheet-Like Heating Element>

As yet another application, it is conceivable to produce a sheet-like heating element using the method for producing a conductive base material of the present embodiment. A sheet-like heating element generates heat by passing electric current through electrical wiring provided on a base material. Specific examples of sheet-like heating elements include sheet-like heating elements for preventing fogging and protection against cold, for the rear glass of a passenger vehicle or the like.

Above, a description was given of the embodiments of the present invention, but these are merely examples of the present invention and it is possible to adopt various other configurations. In addition, the present invention is not limited to the above-described embodiments and includes modifications, improvements, and the like within a range in which it is possible to achieve the purpose of the present invention.

### Examples

The embodiments of the present invention will be explained in detail, based on Examples and Comparative Examples. To be clear, the present invention is not limited to the Examples.

In the following, exponential notation may be indicated by the symbol "E". For example, 1.3E - 06 represents 1.3 × 10⁻⁶.

### <Preparation of Conductive Composition>

77 parts by mass of conductive particles and 23 parts by mass of an organic solvent were stirred using a planetary stirrer. As a result, a uniform paste-like conductive composition was obtained. As the conductive particles, copper powder (D₅₀: 4.5 µm) obtained from Fukuda Metal Foil & Powder Co., Ltd. was used.

For the sake of completeness, this conductive composition does not contain a resin or a binder.

### <Producing of Conductive Base Material>

### (Laminating Step)

A film (a solid film) having a size of 15 mm × 5 mm was formed on a PET film using the conductive composition obtained in <Preparation of conductive composition>.

Specifically, first, a Scotch tape of 3M was attached to a PET film to provide a "cutout portion" having a size of 15 mm × 5 mm. Then, a squeegee was used to squeeze the conductive composition on the cut-out area, filling the cut-out area with the conductive composition. The Scotch tape was then removed. The thickness of the film (undried) at this time was about 40 µm.

The PET film provided with the above-described film was placed in a hot air circulation type atmospheric oven and heated at 100°C for 15 minutes. As a result, the solvent was volatilized.

In this manner, a laminate in which a conductive particle-containing layer was provided on a PET film was obtained.

### (Pressurizing Step)

A polyimide film was placed on the conductive particle-containing layer of the laminate obtained in the laminating step. Then, the laminate was roll-pressed together with the polyimide film using a load-adjustable roll press machine (produced by Tester Sangyo Co., Ltd., "SA-602" equipped with a pair of rolls that rotate facing each other) under the following conditions.
Roll temperature: 110°C for both upper and lower rolls
Pressure: 60 MPa
Transport speed: 0.1 m/min

The roll temperature will be supplemented. The roll press machine is provided with a non-contact temperature sensor, but this time, the roll temperature was measured with a contact type thermometer in order to perform more accurate temperature measurement.

In addition, the pressure was determined by the following calculation.

The roll width was set to 165 mm, the contact width between the rolls was set to 1 mm, and the area subjected to the pressure was calculated as 165 × 1 = 165 mm². In addition, the pressurization force was set to 10 kN. Since a force of 10 kN was applied to a region of 165 mm², the pressure was calculated as 60.6 MPa by calculating 10 kN/165 mm².

After the pressurizing step was completed, the polyimide film was peeled off.

### (Impregnation Step and Conductive Film Formation Step)

First, a liquid having the composition shown in Table 1 below (in which the component (X) was dissolved or dispersed) was added dropwise to the polyimide film using a 1 mL syringe, thereby wetting the polyimide film. The laminate was placed such that the conductive particle-containing layer after the pressurizing step was in contact with the wet portion. Then, the laminate and the polyimide film were set together in a roll press machine and pressurized while being heated. In this manner, while allowing the component (X) to impregnate into the conductive particle-containing layer, the conductive particle-containing layer was used as a roll press machine using the same device as in the pressurizing step. The treatment conditions were as follows.
Roll temperature: 110°C for both upper and lower rolls
Pressure: 121 MPa
Transport speed: 0.1 m/min

After the treatment with the roll press machine, the polyimide film was peeled off.

In this way, a conductive base material provided with a conductive film was produced.

### <Measurement of Specific Resistance>

For the obtained conductive film of the conductive base material, a resistance value was measured with a 4-terminal resistance measuring device, and a film thickness was measured with a film thickness meter. The resistivity was calculated from the measured resistance value and film thickness. A smaller value of the specific resistance is preferable.

The above description is summarized in Table 1.

### [Table 1]

**Table 1**

| Example Number | Solute | Solvent | Concentration | Note | Specific resistance value (Ω·cm) |
|---|---|---|---|---|---|
| 1-1 | Citric acid | Distilled water | 0.25 mol/L | - | 8.82E-06 |
| 1-2 | Citric acid | Distilled water | 0.5 mol/L | - | 6.72E-06 |
| 1-3 | Citric acid | Distilled water | 0.88 mol/L | - | 5.91E-06 |
| 1-4 | Citric acid | Distilled water | 1.5 mol/L | - | 5.60E-06 |
| 1-5 | Citric acid | Distilled water | 2.0 mol/L | - | 5.35E-06 |
| 1-6 | Citric acid | Distilled water | 3.0 mol/L | - | 5.44E-06 |
| 2 | Malonic acid | Distilled water | 1.5 mol/L | - | 4.38E-06 |
| 3-1 | Phosphinic acid | Distilled water | 0.1 mol/L | - | 3.59E-06 |
| 3-2 | Phosphinic acid | Distilled water | 1.5 mol/L | - | 3.56E-06 |
| 3-3 | Phosphinic acid | Distilled water | 3.0 mol/L | - | 3.25E-06 |
| 3-4 | Phosphinic acid | Distilled water | 5.3 mol/L | - | 4.57E-06 |
| 4-1 | Formic acid | Distilled water | 0.1 mol/L | - | 4.34E-06 |
| 4-2 | Formic acid | Distilled water | 1.5 mol/L | - | 3.23E-06 |
| 4-3 | Formic acid | Distilled water | 5.0 mol/L | - | 3.87E-06 |
| 4-4 | Formic acid | Distilled water | 22.9 mol/L | - | 3.50E-06 |
| 5 | Hydrazine | Distilled water | 1.5 mol/L | - | 6.35E-06 |
| 6-1 | Pyrogallol | Distilled water | 1.5 mol/L | | 2.92E-05 |
| 6-2 | Pyrogallol | Distilled water | Pyrogallol: 2.0 % by mass | | 1.27E-05 |
| | Sodium carbonate | | Sodium carbonate: 2.1 % by mass | | |
| 7 | Phenidone | Distilled water | Phenidone: 2.0 % by mass | | 2.05E-05 |
| | Sodium carbonate | | Sodium carbonate: 2.1 % by mass | | |
| 8 | Hydroquinone | Distilled water | Hydroquinone: 2.0 % by mass | | 1.35E-05 |
| | Sodium carbonate | | Sodium carbonate: 2.1 % by mass | Sodium carbonate and sodium sulfite are blended for ph adjustment | |
| 9 | O-aminophenol | Distilled water | O-aminophenol: 0.9 % by mass | | 3.03E-05 |
| | Sodium carbonate | | Sodium carbonate: 5.0 % by mass | | |
| | Sodium sulfite | | Sodium sulfite: 5.0 % by mass | | |
| 10 | Phenidone | Distilled water | Phenidone:0.08 % by mass | | 1.22E-05 |
| | Hydroquinone | | Hydroquinone: 0.7 % by mass | | |
| | Sodium sulfite | | Sodium sulfite 10.0 % by mass | | |
| Comparative Example | Only distilled water | | | | 4.49E-05 |

The specific resistances of the conductive films obtained in Examples 1-1 to 10 were smaller than the specific resistances of the conductive films obtained in Comparative Examples. From this, it is understood that in a case of forming a conductive film using a conductive composition containing conductive particles, the specific resistance of the obtained conductive film can be reduced by removing at least a part of the oxide film on the surface of the conductive particles using the component (X) capable of removing the oxide film on the surface of the conductive particles.

In a case where pyrogallol, phenidone, hydroquinone, or o-aminophenol was used as the component (X) in Examples 6-1 to 10, the specific resistance of the obtained conductive film was on the order of 10⁻⁵ Ω·cm.

On the other hand, in Examples 1-1 to 5, in a case where various organic acids, phosphinic acid (an oxoacid of phosphorus), or hydrazine was used, a conductive film having a resistivity of 10⁻⁶ Ω·cm order, which is smaller than the resistivity of 10⁻⁵ Ω·cm order, could be obtained.

From the comparison between Examples, it is understood that the component (X) is preferably various organic acids, an oxoacid of phosphorus, hydrazine, or a derivative thereof.

In addition, from the results of Examples 1-1 to 1-6, 3-1 to 3-4, and 4-1 to 4-4, it can be read that the specific resistance of the obtained conductive film is not always smaller as the concentration of the component (X) is higher, and the specific resistance tends to be increased slightly by increasing the concentration of the component (X). It is presumed that this is due to a balance between the improvement of the removability of the oxide film by increasing the concentration of the component (X) and the increase in electrical resistance due to the fact that a part of the component (X) at a high concentration remains in the conductive film.

### <Example in which Pressure of Pressurizing Step was Changed>

In Examples 3-1 and 3-2 of Table 1, the pressure in the above-described (pressurizing step) was changed from 60 MPa to 90 MPa which is 1.5 times or 120 MPa which is 2 times, thereby obtaining a conductive film. Then, the specific resistance was measured in the same manner as in <Measurement of specific resistance>. The results are shown in Table 2.

### [Table 2]

**Table 2**

| | Specific resistance value (Ω·cm) |
|---|---|
| Example 3-1 (described above) | 3.59E-06 |
| Pressure of pressurizing step in Example 3-1 is changed to 90 MPa | 6.81E-06 |
| Pressure of pressurizing step in Example 3-1 is changed to 120 MPa | 6.69E-06 |
| Example 3-2 (described above) | 3.56E-06 |
| Pressure of pressurizing step in Example 3-2 is changed to 90 MPa | 3.74E-06 |
| Pressure of pressurizing step in Example 3-2 is changed to 120 MPa | 3.70E-06 |

As shown in Table 2, in a case where the pressure in the pressurizing step is increased particularly in a case where the concentration of the component (X) (phosphinic acid) is low, the specific resistance of the obtained conductive film tends to be slightly increased. In other words, a conductive film having a lower specific resistance could be obtained in a case where the pressure in the pressurizing step was relatively low. It is presumed that this is because the smaller the pressure in the pressurizing step, the more appropriate "gap" remains in the conductive particle-containing layer, and the component (X) easily impregnates into the conductive particle-containing layer in the impregnation step.

### <Example in which Not Only Pressure But Also Temperature of Pressurizing Step was Changed>

In Example 3-2 of Table 1, the temperature was changed from 110°C to room temperature (25°C) in addition to the pressure in the (pressurizing step) being changed, thereby obtaining a conductive film. Then, the specific resistance was measured in the same manner as in <Measurement of specific resistance>. The results are shown in Table 3.

### [Table 3]

**Table 3**

| | Specific resistance value (Ω·cm) |
|---|---|
| Example 3-2 (described above) | 3.56E-06 |
| Temperature of pressurizing step in Example 3-2 is changed to room temperature (25°C) | 3.69E-06 |
| Pressure of pressurizing step in Example 3-2 is changed to 90 MPa (described above) | 3.74E-06 |
| Pressure of pressurizing step in Example 3-2 is changed to 90 MPa, and the temperature is changed to room temperature (25°C) | 4.00E-06 |
| Pressure of pressurizing step in Example 3-2 is changed to 120 MPa (described above) | 3.70E-06 |
| Pressure of pressurizing step in Example 3-2 is changed to 120 MPa, and the temperature is changed to room temperature (25°C) | 3.84E-06 |

As shown in Table 3, in the pressurizing step, in a case where the pressure is the same, a conductive film having a smaller specific resistance can be obtained by carrying out the treatment at a high temperature (110°C) than by carrying out the treatment at room temperature (25°C).

This is presumed to be because the organic substance on the surface of the conductive particles (copper powder) used this time is removed or moved by heating, and the contact between the conductive particles is promoted.

### <Example of Changing Pressure in Conductive Film Formation Step>

In Example 3-2 of Table 1, the pressure in the (impregnation step and conductive film formation step) was changed from 121 MPa to the value shown in Table 4 to obtain a conductive film. Then, the specific resistance was measured in the same manner as in <Measurement of specific resistance>. The results are shown in Table 4.

### [Table 4]

**Table 4**

| | Specific resistance value (Ω·cm) |
|---|---|
| Example 3-2 (described above, pressure of 121 MPa) | 3.56E-06 |
| Pressure of conductive film formation step in Example 3-2 is changed to 91 MPa | 3.88E-06 |
| Pressure of conductive film formation step in Example 3-2 is changed to 61 MPa | 4.07E-06 |
| Pressure of conductive film formation step in Example 3-2 is changed to 36 MPa | 5.45E-06 |

As shown in Table 4, in a case where the pressure in the conductive film formation step was set to be lower than 121 MPa in Example 3-2, the specific resistance of the obtained conductive film was slightly increased. However, even in a case of the pressure of 36 MPa, the specific resistance of the obtained conductive film was sufficiently smaller than that of Comparative Example in Table 1.

### <Example in which Temperature of Conductive Film Formation Step was Changed>

In Examples 3-1 and 3-2 of Table 1, the temperature in the (impregnation step and conductive film formation step) was changed from 110°C to the values shown in Table 5 to obtain a conductive film. Then, the specific resistance was measured in the same manner as in <Measurement of specific resistance>. The results are shown in Table 5.

**[Table 5]**

| | Specific resistance value (Ω·cm) |
|---|---|
| Example 3-1 (described above) | 3.59E-06 |
| Temperature of conductive film formation step in Example 3-1 is changed to 150°C | 8.55E-06 |
| Temperature of conductive film formation step in Example 3-1 is changed to 200°C | 7.28E-06 |
| Example 3-2 (described above) | 3.56E-06 |
| Temperature of conductive film formation step in Example 3-2 is changed to 150°C | 4.52E-06 |
| Temperature of conductive film formation step in Example 3-2 is changed to 200°C | 5.27E-06 |

From Table 5, it is understood that the heating temperature in the conductive film formation step is preferably not too high from the viewpoint of further reducing the specific resistance of the conductive film. However, even at a relatively high heating temperature of 150°C or 200°C, a conductive film having a sufficiently low resistivity as compared with Comparative Examples in Table 1 is obtained.

### <Example in which Polyimide Film was not Used in Impregnation Step and Conductive Film Formation Step>

In Example 4-2 of Table 1, a conductive film was obtained without using a polyimide film (film-like material) in the (impregnation step and conductive film formation step). Specifically, first, a liquid containing the component (X) was directly added dropwise to the conductive particle-containing layer of the laminate obtained in the (laminating step) using a 1 mL micropipette, and then the laminate was set in a roll press machine and pressurized while being heated. As a result, a conductive base material was obtained. Then, the specific resistance was measured in the same manner as in <Measurement of specific resistance>.

In this example, a roll that had been subjected to a release treatment was used as the roll of the roll press machine. This is because, in a case where the polyimide film (film-like material) is not used, the conductive film is easily peeled off by being attached to the roll.

The measurement result of the specific resistance was 3.67E-6 Ω·cm. That is, a conductive film having a specific resistance comparable to that of a conductive film formed using a film-like material could be formed without using the film-like material in the impregnation step and the conductive film formation step.

### <Example in which Component (X) was Impregnated into Conductive Particle-Containing Layer Using Paper Containing Component (X) instead of Liquid Containing Component (X)>

In the above (impregnation step and conductive film formation step), instead of using the polyimide film and the liquid having the composition shown in Table 1, paper containing a 1.5 mol/L formic acid aqueous solution was brought into contact with the conductive particle-containing layer, and heating and pressurization were performed with a roll press machine. Then, the specific resistance of the obtained conductive film was measured in the same manner as in

### <Measurement of specific resistance>.

The specific resistance of the obtained conductive film was 4.36E-6 Ω·cm. That is, a conductive film having a small specific resistance can be obtained not only by using a liquid containing the component (X) but also by bringing a "sheet" containing the component (X) into contact with the conductive particle-containing layer.

### <Example in which Conductive Composition was Changed and Pressurizing Step was not Performed>

In Example 4-2 of Table 1, the conductive base material was obtained by changing the following two points. Then, the specific resistance of the conductive film was measured in the same manner as in <Measurement of specific resistance> described above.

### • Change 1

As the conductive composition, a composition containing a resin was used. Specifically, a conductive composition in the form of a uniform paste was used, which was obtained by stirring 79 parts by mass of conductive particles (copper powder obtained from Fukuda Metal Foil & Powder Co., Ltd., D₅₀: 4.5 µm), 2 parts by mass of a commercially available polyester resin, and 19 parts by mass of an organic solvent using a planetary stirrer.

### • Change 2

(The pressurizing step) was not performed. That is, the laminate obtained in the (laminating step) was subjected to the (impregnation step and conductive film formation step) as it was.

In this example, a conductive film having a specific resistance value of 5.75E-6 Ω·cm was able to be obtained. That is, by using the conductive composition containing a resin, a good conductive film could be obtained without carrying out the pressurizing step.

### <Observation of Component (X) Remaining in Conductive Film>

The conductive film obtained in Example 4-4 was observed with a scanning electron microscope. In this observation, the presence of a substance considered to be a salt formed of copper ions and formic acid was confirmed. That is, at least the conductive base material obtained in Example 4-4 contained a base material and a conductive film provided on at least a part of a surface of the base material, and the component (X) (formic acid) was present on a surface or inside the conductive film.

This application claims priority based on Japanese Patent Application No. 2022-199931 filed on December 15, 2022, the entire disclosure of which is incorporated herein by reference.

### REFERENCE SIGNS LIST

1 base material
3 film
3B conductive particle-containing layer
5A film-like material
5B film-like material
10A roll
10B roll
10C roll
10D roll
50 liquid containing component (X)

## Claims

1. A method for producing a conductive base material, the method comprising:
a laminating step of forming a conductive particle-containing layer on a surface of a base material using a conductive composition containing conductive particles, to obtain a laminate containing a base material layer and the conductive particle-containing layer;
an impregnation step of impregnating a component (X) capable of removing an oxide film on a surface of the conductive particles into the conductive particle-containing layer; and
a conductive film formation step of at least pressurizing the conductive particle-containing layer impregnated with the component (X) to form a conductive film.

2. The method for producing a conductive base material according to Claim 1, further comprising:
a pressurizing step of at least pressurizing the conductive particle-containing layer between the laminating step and the impregnation step.

3. The method for producing a conductive base material according to Claim 2,
wherein, in a case where a pressure applied to the conductive particle-containing layer in the pressurizing step is denoted by P1 and a pressure applied to the conductive particle-containing layer in the conductive film formation step is denoted by P2, P1 < P2 is satisfied.

4. The method for producing a conductive base material according to Claim 1 or 2,
wherein in the impregnation step, a liquid in which the component (X) is dissolved or dispersed is impregnated into the conductive particle-containing layer.

5. The method for producing a conductive base material according to Claim 4,
wherein the liquid contains water.

6. The method for producing a conductive base material according to Claim 4,
wherein the liquid in which the component (X) is dissolved or dispersed is supplied to at least a surface of the conductive particle-containing layer by any one of a dropping method, a spraying method, or an immersion method between the laminating step and the impregnation step.

7. The method for producing a conductive base material according to Claim 1 or 2,
wherein in the impregnation step, the component (X) is impregnated into the conductive particle-containing layer by bringing a sheet containing the component (X) into contact with the conductive particle-containing layer.

8. The method for producing a conductive base material according to Claim 1 or 2,
wherein in the conductive film formation step, the conductive particle-containing layer is pressurized while being heated.

9. The method for producing a conductive base material according to Claim 1 or 2,
wherein, in the conductive film formation step, a surface of the laminate on which the conductive particle-containing layer is provided is covered with a film-like material, and then the conductive particle-containing layer is at least pressurized.

10. The method for producing a conductive base material according to Claim 1 or 2,
wherein the impregnation step and the conductive film formation step are performed at the same time.

11. The method for producing a conductive base material according to Claim 1 or 2,
wherein the conductive film formation step is performed after the impregnation step.

12. The method for producing a conductive base material according to Claim 1 or 2, further comprising:
a removing step of removing the component (X) remaining on a surface or inside the conductive film after the conductive film formation step.

13. The method for producing a conductive base material according to Claim 1 or 2,
wherein the component (X) includes at least one selected from the group consisting of an organic acid, an oxoacid of phosphorus, and hydrazine or a derivative thereof.

14. The method for producing a conductive base material according to Claim 1 or 2,
wherein the conductive composition contains one or both of a resin and a binder.

15. The method for producing a conductive base material according to Claim 1 or 2,
wherein the conductive composition substantially does not contain a resin and substantially does not contain a binder.

16. The method for producing a conductive base material according to Claim 1 or 2,
wherein the base material is flexible.

17. The method for producing a conductive base material according to Claim 1 or 2,
wherein the base material is at least one selected from the group consisting of polyester, polyolefin, polyimide, and paper.

18. The method for producing a conductive base material according to Claim 1 or 2,
wherein the impregnation step is performed by applying pressure to the conductive particle-containing layer with a pressing member.

19. The method for producing a conductive base material according to Claim 1 or 2,
wherein the impregnation step is performed as any one of the following (i) to (iii),
(i) the laminate is transported between two rolls facing each other while the laminate is interposed between the two rolls,
(ii) the laminate is placed on a flat plate or a flat surface of a base having the flat surface, a roll is brought into contact with the laminate from above, and pressure is applied to the laminate while rotating the roll, and
(iii) the laminate is interposed between a first flat surface of a first pressing member having the first flat surface and a second flat surface of a second pressing member having the second flat surface.

20. The method for producing a conductive base material according to Claim 1 or 2,
wherein the conductive film has a pattern structure.

21. The method for producing an electronic device,
wherein an electronic device is produced using the conductive base material obtained by the method for producing a conductive base material according to Claim 1 or 2.

22. The method for producing an electronic device according to Claim 21,
wherein the electronic device is an RF tag.

23. A method for producing an electromagnetic shield film,
wherein an electromagnetic shield film is produced using the conductive base material obtained by the method for producing a conductive base material according to Claim 1 or **2.**

24. A method for producing a sheet-like heating element,
wherein a sheet-like heating element is produced using the conductive base material obtained by the method for producing a conductive base material according to Claim 1 or 2.

25. A conductive base material comprising:
a base material; and
a conductive film provided on at least a part of a surface of the base material using a conductive composition containing conductive particles,
wherein a component (X) capable of removing an oxide film on a surface of the conductive particles is present on a surface or inside the conductive film.
